# EUROPEAN PATENT APPLICATION

(11) **EP 2 403 065 A2**
(43) Date of publication of application: **04.01.2012**
(21) Application number: 11250424.6
(22) Date of filing: 04.04.2011
(51) Int. Cl.: H01Q 1/40, H01Q 1/38, H01Q 1/24

(54) **Electronic device case having antenna pattern embedded therein, method for manufacturing the same, mold for manufacturing antenna pattern frame, and electronic device**

(30) Priority: 30.06.2010 KR 20100063078
(71) Applicant: Samsung Electro-Mechanics Co., Ltd., Gyeonggi-do (KR)
(72) Inventor: Lee, Dae Kyu, Gyunggi-do (KR); Sung, Jae Suk, Gyunggi-do (KR); Cho, Sung Eun, Gyunggi-do (KR); An, Chan Gwang, Gyunggi-do (KR); Hong, Ha Ryong, Gyunggi-do (KR); Chang, Ki Won, Gyunggi-do (KR)
(74) Representative: Powell, Timothy John

(57) **Abstract**

An electronic device case includes: a radiator including an antenna pattern part transmitting or receiving a signal and a connection terminal part allowing the signal to be transmitted to or received from a circuit board of an electronic device; a radiator frame including the radiator injection-molded thereon, separated from the connection terminal part so that the connection part can have elasticity, and having a radiator support protruded from the opposite surface of one surface on which the antenna pattern part is formed; and a case frame covering one surface of the radiator frame to allow the antenna pattern part to be embedded between the case frame and the radiator frame.

## Description

### CROSS-REFERENCE TO RELATED APPLICATIONS

This application claims the priority of Korean Patent Application No. 10-2010-0063078 filed on June 30, 2010, in the Korean Intellectual Property Office, the disclosure of which is incorporated herein by reference.

### BACKGROUND OF THE INVENTION

### Field of the Invention

The present invention relates to an electronic device case having an antenna pattern embedded therein, a method for manufacturing the same, a mold for manufacturing an antenna pattern frame, and an electronic device, and more particularly, to an electronic device case including an antenna radiator having an altered connection terminal part structure, a method for manufacturing the same, a mold for manufacturing an antenna pattern frame, and an electronic device.

### Description of the Related Art

Mobile communication terminals such as a mobile phone, a personal digital assistant (PDA), a navigation device, a notebook computer, and the like, supporting radio communications are requisite devices in modern society. Mobile communication terminals are evolving to have additional functions such as CDMA, wireless LAN, GSM, DMB, and the like, and one of the most important components enabling these functions is an antenna.

Antennas employed for mobile communication terminals have evolved from an external type antenna such as a rod antenna or a helical antenna to an internal type antenna disposed within a terminal.

The external type antenna is vulnerable to an external impact, and the internal type antenna leads to an increase in the volume of a terminal.

Thus, in order to solve the problem, research into the integration of an antenna into a mobile communication terminal is actively ongoing.

In the related art, a radiator is injection-molded to form an antenna pattern frame, and the antenna pattern frame is injection-molded again so as to allow the radiator be embedded in an electronic device case.

A connection terminal part of the embedded radiator needs to be in contact with a main circuit board for an electrical connection therebetween in the terminal. As the connection terminal part of the related art does not have elasticity and has a planar surface or a curved surface, the connection terminal is in use without any movement.

Thus, in order to connect the connection terminal part to the main circuit board, an additional element having elasticity is added to the main circuit board to allow the connection terminal part to be brought into contact with the main circuit board thereby, causing a problem in that a unit cost increases as a result of the addition of the element.

In addition, the additionally performed process of adding the additional element lengthens the manufacturing time and the additional element is deformed or released from its original position due to an external impact applied thereto, causing a problem of a short circuit to result in the degradation of the ability of a product to compete in the marketplace.

### SUMMARY OF THE INVENTION

An aspect of the present invention provides an electronic device case having an antenna pattern embedded therein, a manufacturing method thereof, and an electronic device.

Another aspect of the present invention provides a manufacturing mold for manufacturing an antenna pattern frame provided to an electronic device case.

Another aspect of the present invention provides an electronic device case having an antenna pattern embedded therein, capable of securing a stable structure in transferring an antenna signal, thus preventing the occurrence of a short circuit due to an external impact.

According to an aspect of the present invention, there is provided an electronic device case including: a radiator including an antenna pattern part transmitting or receiving a signal and a connection terminal part allowing the signal to be transmitted to or received from a circuit board of an electronic device; a radiator frame including the radiator injection-molded thereon, separated from the connection terminal part so that the connection part can have elasticity, and having a radiator support protruded from the opposite surface of one surface on which the antenna pattern part is formed; and a case frame covering one surface of the radiator frame to allow the antenna pattern part to be embedded between the case frame and the radiator frame.

The connection terminal part may include a contact projection formed to be in point-contact with the circuit board.

The connection terminal part may include a bent portion formed by bending one end of the connection terminal part, and the contact projection may be formed on the bent portion.

The electronic device case may further include: an elastic member provided between the connection terminal part and the radiator support to increase the elasticity of the connection terminal part.

The elastic member may be made of at least one of silicon or rubber as an insulating material.

The radiator may include a connection part, as part of the radiator, connecting the antenna pattern part and the connection terminal part, and the connection part may connect the antenna pattern part and the connection terminal part such that the antenna pattern part is formed on one surface of the radiator frame and the connection terminal part is formed on the opposite surface of the one surface.

The connection part may be supported such that one surface of the connection part is in contact with the radiator support.

The electronic device case may further include: at least one reinforcing portion formed at the boundary between the connection part and the connection terminal part to secure an elastic force of the connection terminal part.

The reinforcing portion may be a reinforcing bead formed to be protruded at the boundary between the connection part and the connection terminal part.

The reinforcing portion may be formed make the boundary between the connection part and the connection terminal part rounded.

The electronic device case may further include: an injection reinforcing portion formed to be in contact with one side of the connection part to prevent the connection part from being released from the radiator support.

The injection reinforcing portion may be integrally formed with the radiator frame.

According to another aspect of the present invention, there is provided an electronic device including: an electronic device case including an antenna pattern embedded therein; and a circuit board connected to a connection terminal part to transmit and receive a signal of a radiator.

The electronic device case may include a fastening part formed on at least one side of the electronic device case and coupled with a main case forming an external appearance of the electronic device.

The fastening part may be protruded from one side of the electronic device case having the antenna pattern embedded therein, and the main case includes a fastening line recess corresponding to the fastening part to allow the fastening part to be inserted into the fastening line recess and slidably coupled therein.

According to another aspect of the present invention, there is provided a mold for manufacturing an antenna pattern frame, including: upper and lower molds in which a radiator, including an antenna pattern part for transmitting and receiving a signal, a connection terminal part connected to a circuit board of an electronic device, and a connection part connecting the antenna pattern part and the connection terminal part, is accommodated; and a resin material injection part formed on the upper mold, the lower mold or on at least one of the upper and lower molds to allow a resin material to be introduced into an internal space between the upper and lower molds so as to form a radiator frame allowing the antenna pattern to be embedded in the interior of the electronic device by the internal space between the upper and lower molds when the upper and lower molds are combined, wherein the lower mold includes an accommodation recess for accommodating the connection part and the connection terminal part, the resin material is introduced into the accommodation recess to support both sides of the connection part, and the radiator becomes the radiator frame by the internal space.

The accommodation recess may have different depths based on the connection part as a boundary so that portions supporting the side of the connection part can be different.

According to another aspect of the present invention, there is provided a method for manufacturing an electronic device case having an antenna pattern embedded therein, including: injection-molding a radiator frame having a radiator such that an antenna pattern part for transmitting and receiving a signal and a connection terminal part allowing the signal to be transmitted to or received from a circuit board of an electronic device are disposed on different planes of the radiator; injection-molding a case frame covering one surface of the radiator frame to make the antenna pattern part embedded between the case frame and the radiator frame; and separating the connection terminal part from the case frame and providing elasticity to the connection terminal part.

The radiator frame may include a radiator support protruded from the opposite surface of one surface on which the antenna pattern part is formed in order to allow the connection terminal part to have elasticity.

The method may further include: inserting an elastic member between the connection terminal part and the case frame in order to increase the elasticity of the connection terminal part, after elasticity is provided to the connection terminal part.

The elastic member may be made of at least one of silicon or rubber as an insulating material.

The radiator may include a connection part, as part of the radiator, connecting the antenna pattern part and the connection terminal part such that the antenna pattern part and the connection terminal part are positioned on different planes, and may include at least one reinforcing portion formed at a boundary between the connection part and the connection terminal part to secure an elastic force of the connection terminal part.

The radiator frame may include a radiator support protruded from the opposite surface of one surface on which the antenna pattern part is formed to allow the connection terminal part to have elasticity, and the connection part may be supported such that one side of the connection part is in contact with the radiator support.

### BRIEF DESCRIPTION OF THE DRAWINGS

The above and other aspects, features and other advantages of the present invention will be more clearly understood from the following detailed description taken in conjunction with the accompanying drawings, in which:

FIG. 1 is a schematic perspective view showing a case of a mobile communication terminal, an electronic device, with a cutaway portion according to an exemplary embodiment of the present invention;

FIG. 2 is an exploded schematic perspective view of the mobile communication terminal manufactured by using an antenna pattern frame according to an exemplary embodiment of the present invention;

FIGS. 3a to 3c are schematic perspective views of a radiator provided to the antenna frame according to an exemplary embodiment of the present invention;

FIGS. 4 and 5a to 5c are schematic perspective views of the antenna pattern frame according to an exemplary embodiment of the present invention;

FIG. 6a is a schematic sectional view of an antenna pattern frame taken along line A-A of FIG. 4a according to a first exemplary embodiment of the present invention;

FIG. 6b is a schematic sectional view showing the filling of a mold with a resin material for manufacturing an antenna pattern frame to manufacture the antenna pattern frame of FIG. 6a;

FIG. 7a is a schematic sectional view of an antenna pattern frame according to a second exemplary embodiment of the present invention;

FIG. 7b is a schematic sectional view showing the filling of a mold with a resin material for manufacturing an antenna pattern frame to manufacture the antenna pattern frame of FIG. 7a;

FIG. 8a is a schematic sectional view of an antenna pattern frame according to a third exemplary embodiment of the present invention;

FIG. 8b is a schematic sectional view showing the filling of a mold with a resin material for manufacturing an antenna pattern frame to manufacture the antenna pattern frame of FIG. 8a;

FIG. 9 is a schematic view showing an electronic device case including an antenna pattern radiator embedded therein according to another exemplary embodiment of the present invention;

FIG. 10 is a schematic sectional view showing the filling of a mold with a resin material for manufacturing an electronic device case to manufacture the electronic device case including the antenna pattern embedded therein according to another exemplary embodiment of the present invention;

FIGS. 11a to 11c are schematic sectional view showing an electronic device case including an antenna pattern radiator embedded therein according to another exemplary embodiment of the present invention;

FIG. 12 is a schematic sectional view showing the providing of elasticity to a connection terminal part in manufacturing the electronic device case including the antenna pattern embedded therein according to another exemplary embodiment of the present invention; and

FIG. 13 is a schematic sectional view showing the inserting of an elastic member in manufacturing the electronic device case including the antenna pattern embedded therein according to another exemplary embodiment of the present invention.

### DETAILED DESCRIPTION OF THE PREFERRED EMBODIMENT

Exemplary embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art.

In the drawings, the shapes and dimensions may be exaggerated for clarity, and the same reference numerals will be used throughout to designate the same or like components.

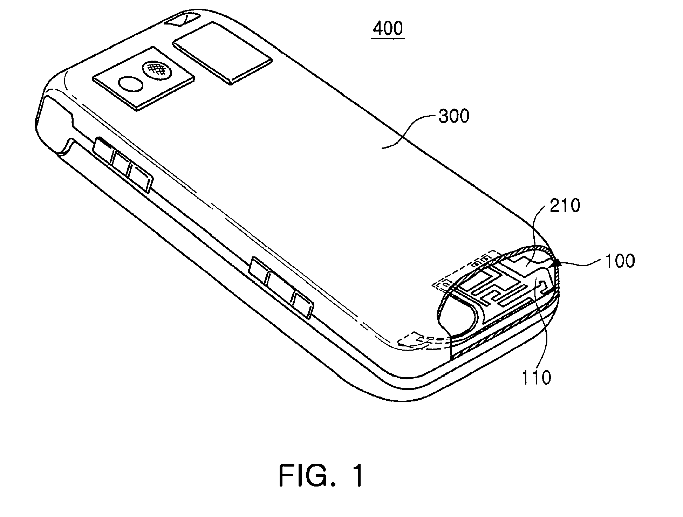

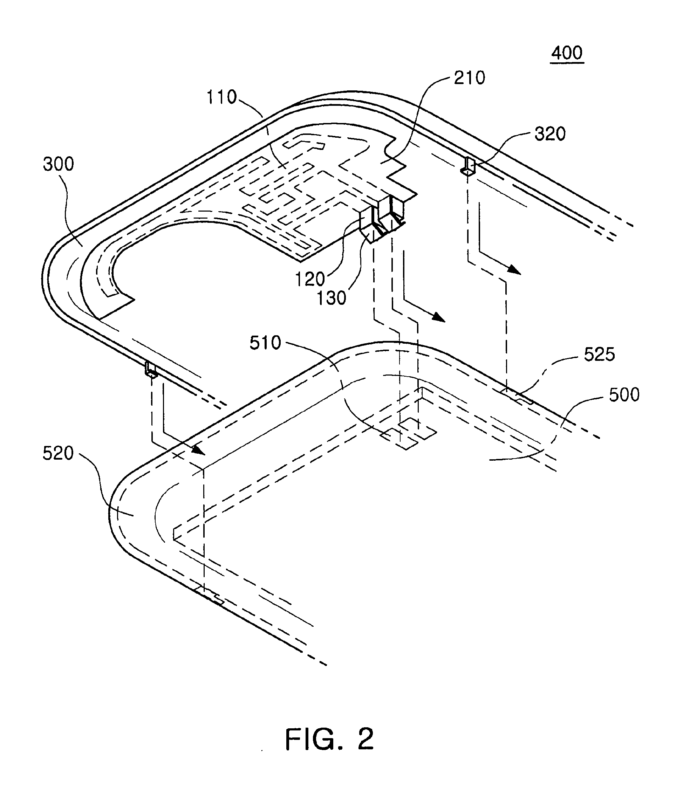

FIG. 1 is a schematic perspective view showing a case of a mobile communication terminal, an electronic device, with a cutaway portion according to an exemplary embodiment of the present invention, and FIG. 2 is an exploded schematic perspective view of the mobile communication terminal manufactured by using an antenna pattern frame according to an exemplary embodiment of the present invention.

With reference to FIGS. 1 and 2, a radiator 100 including an antenna pattern part 110 may be embedded in a case 300 of a mobile communication device 400, an electronic device, according to an exemplary embodiment of the present invention.

In order to embed the antenna pattern part 110 within the electronic device case 300, a radiator frame 210 having the antenna pattern formed thereon is required.

Here, the radiator 100 may include a connection terminal part 130 to be connected to a terminal 510 of a circuit board 500, and as the connection terminal part 130 is connected to the circuit board 500, the electronic device case 300 may implement an antenna performance in the mobile communication terminal 400.

A fastening part 320 may be provided to at least one side of the electronic device case 300 in which the antenna pattern part 110 is embedded, so as to be fastened to a main case 520 forming an external appearance of the mobile communication terminal 400 as an electronic device.

The fastening part 320 is protruded from one side of the electronic device case 300 in which the antenna pattern is embedded. The main case 520 includes a fastening line recess 525 corresponding to the fastening part 320, so that the fastening part 320 can be inserted into the fastening line recess 525 and slidably fastened thereto.

Alternatively, the protruded fastening part 320 may be formed on the main case 520 and the fastening line recess 525 may be formed on the electronic device case 300 in which the antenna pattern is embedded, so as to be slidably fastened thereto.

**Antenna pattern frame, and mold and method for manufacturing the antenna pattern frame**

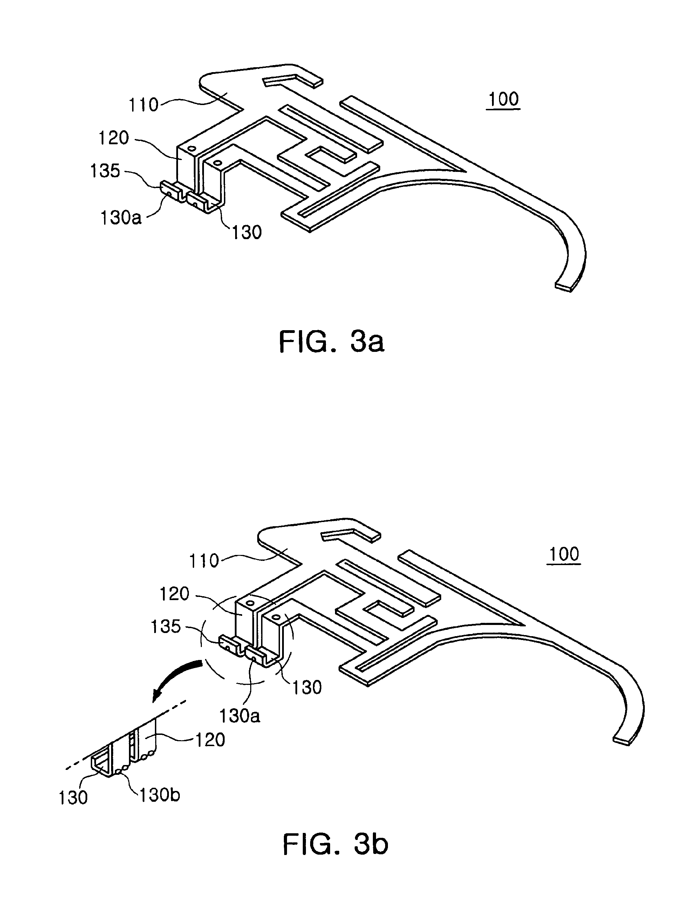

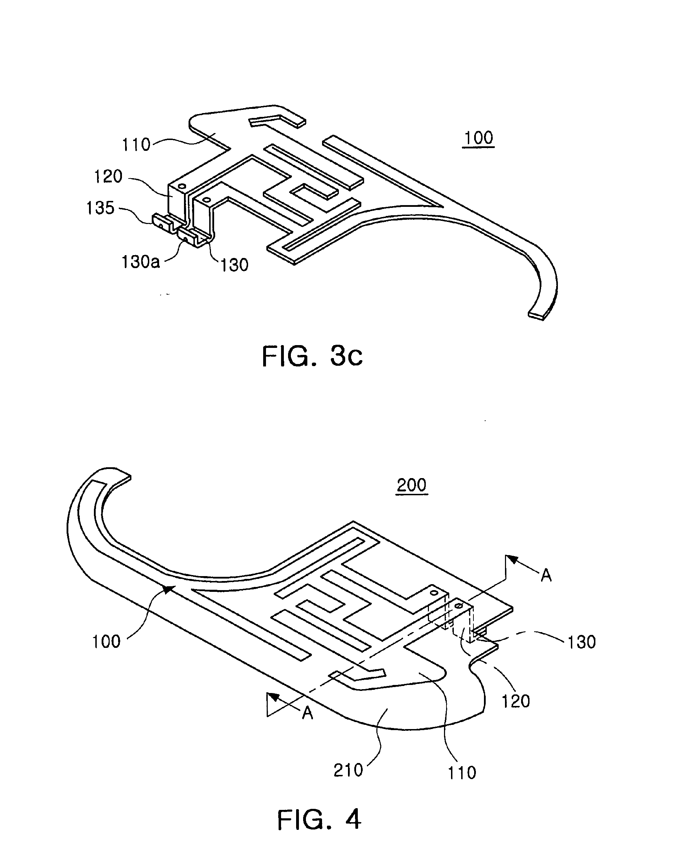

FIGS. 3a to 3c are schematic perspective views of a radiator provided to the antenna frame according to an exemplary embodiment of the present invention.

An antenna pattern frame 200 is manufactured by injection-molding the radiator 100, and the radiator 100 provided to the antenna pattern frame 200 may include an antenna pattern part 110 for transmitting or receiving a signal and a connection terminal part 130 allowing the signal to be transmitted to or received from the circuit board 500.

With reference to FIGS. 3a to 3c, the radiator 100 provided to the antenna pattern frame 200 according to an exemplary embodiment of the present invention may include the antenna pattern part 100, the connection part 120, and the connection terminal part 130.

The radiator 100, formed as a conductor made of aluminum or copper, receives an external signal and transfers the received signal to a signal processing unit of an electronic device such as the mobile communication terminal 400. Also, the radiator 100 may include the antenna pattern part 110 forming a meander line to receive external signals of various bands.

The radiator 100 may include the antenna pattern part 110 for receiving an external signal and the connection terminal part 130 in contact with the circuit board 500 of the electronic device in order to transmit the external signal.

Also, the antenna pattern part 110 and the connection terminal part 130 of the radiator 100 may be bent to have a three-dimensional structure, and the antenna pattern part 110 and the antenna terminal part 130 may be connected by the connection part 120.

The connection part 120 allows the antenna pattern part 110 and the connection terminal part 130 to be formed on different planes, and allows the connection terminal part 130, which is not embedded in the electronic device case 300, to be exposed from the opposite side of one side on which the antenna pattern part 110 is formed.

Here, the connection terminal part 130 allows a signal received from the antenna pattern part 110 to be transmitted to the circuit board 500 of the electronic device, and preferably, the connection terminal part 130 is in point-contact with the terminal 510 of the circuit board 500 in order to secure reliability in the signal transmission.

Thus, the connection terminal part 130 may include a contact projection 130a to be in point-contact with the circuit board 500 of the electronic device, and as the protruded contact projection 130a is in contact with the terminal 510 of the circuit board 500, the reliability of the signal transmission through the point contact can be obtained.

Here, the connection terminal part 130 may have a bent portion 135 formed by bending the connection terminal part 130 in order to provide the contact projection 130a, and the contact projection 130a may be formed on the bent portion 135.

A reinforcing portion 135b may be formed at the boundary between the connection part 120 and the connection terminal part 130.

The reinforcing portion 130b may be configured to secure an elastic force of the connection terminal part 130. After the antenna pattern-embedded electronic device case 300 is injection-molded, the connection terminal part 130 is bent by applying an external force to provide elasticity to the connection terminal part 130, and in this case, the reinforcing portion 130b is formed at the boundary between the connection part 120 and the connection terminal part 130 to secure the elastic force of the connection terminal part 130.

The presence of the reinforcing portion 130b strengthens the boundary between the connection part 120 and the connection terminal part 130, and prevents the connection terminal part 130 from being damaged by an external impact.

Here, the reinforcing portion 130b may be a reinforcing bead formed to be protruded from the boundary between the connection part 120 and the connection terminal part 130 or may be formed by rounding the boundary between the connection part 120 and the connection terminal part 130.

However, the reinforcing part 130b may not be limited to the reinforcing bead 130b or the rounded configuration, and any means may be used so long as it can secure an elastic force of the connection terminal part 130 and prevent the connection terminal part 130 from being damaged by an external force.

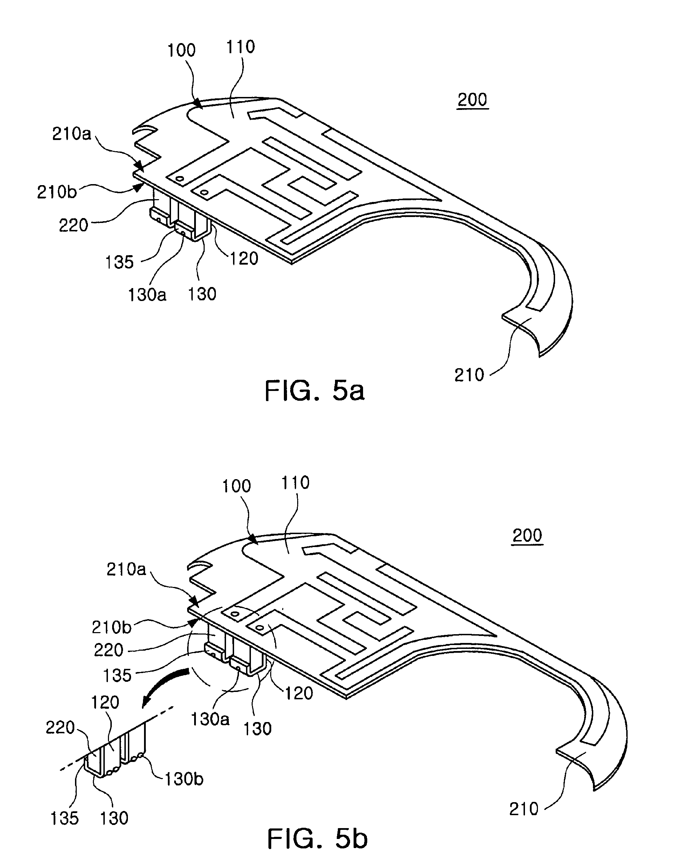

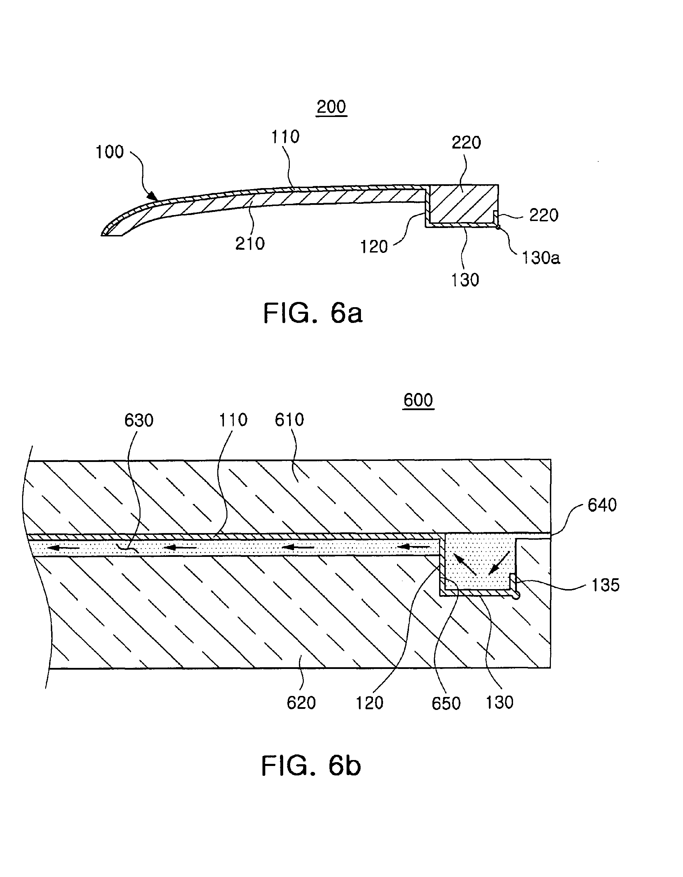

FIGS. 4 and 5a to 5c are schematic perspective views of the antenna pattern frame according to an exemplary embodiment of the present invention. FIGS. 6a, 7a, and 8a are schematic sectional views of the antenna pattern frame according to first to third exemplary embodiments of the present invention (FIG. 6a is a sectional view taken along line A-A in FIG. 4), and FIGS.6b, 7b, and 8b are schematic sectional views showing the filling of a mold with a resin material for manufacturing an antenna pattern frame to manufacture the antenna pattern frames of FIG. 6a, 7a, and 8a.

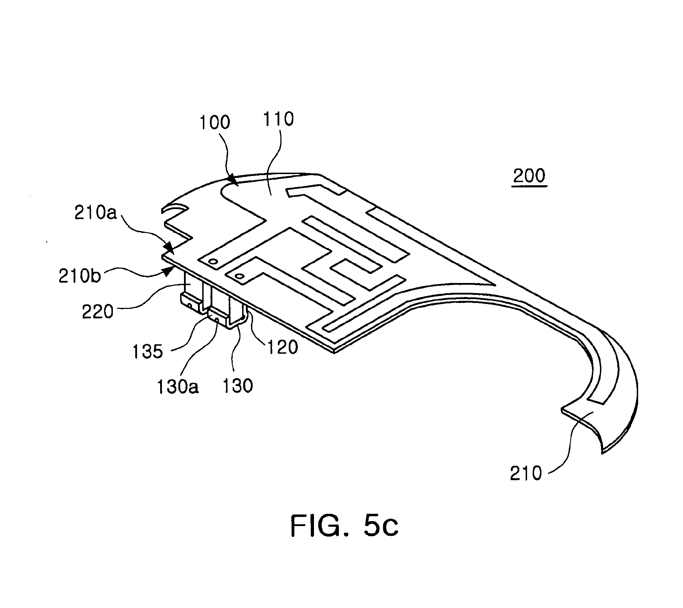

With reference to FIGS. 4, 5a, and 5c, the antenna pattern frame 200 may include the radiator 100 and the radiator frame 210.

Here, the configuration of the radiator 210 has been described in detail, so a repeated description thereof will be omitted.

The radiator frame 210 may be manufactured as the radiator 100 is injection-molded and separated from the connection terminal part 130 to allow the connection terminal part 130 to have elasticity, and may have a radiator support protruded from the opposite surface 210b of one surface 210a on which the antenna pattern part 110 is formed.

Namely, the radiator frame 210 is an injection-molded structure, and the antenna pattern part 110 may be formed on one surface 210a of the radiator frame 210 and the connection terminal part 130 may be formed on the opposite surface 210b of the one surface 210a.

The one surface 210a, with the antenna pattern part 110 formed thereon, of the radiator frame 210 may be attached at the inner side of the electronic device case 300 to embed the antenna pattern at the inner side of the electronic device case 300.

The radiator support 220, integrally formed with the radiator frame 210, will be described later when a mold and method for manufacturing the antenna pattern frame 200 are explained.

With reference to FIGS. 6a and 6b, in manufacturing the antenna pattern frame 200 according to a first exemplary embodiment of the present invention, the radiator 100 is inserted into an internal space 630 of an antenna pattern frame manufacturing mold 600.

Namely, the radiator 100, including the antenna pattern part 110 for transmitting or receiving a signal and a connection terminal part 130 for allowing the signal to be transmitted to or received from the circuit board 500 of the electronic device, which are formed on the mutually different planes of the radiator 100, is disposed in the internal space 630 of the antenna pattern frame manufacturing mold 600.

Here, the radiator 100 may include the contact projection 130a and the reinforcing portion130b as mentioned above.

The antenna pattern frame manufacturing mold 600 may have the internal space 630 in which the radiator 100 is accommodated, and the internal space 630 may be generated as upper and lower molds 610 and 620 of the antenna pattern frame manufacturing mold 600 are combined.

Namely, the internal space 630 is formed as the upper mold 610 and the lower mold 620 are combined, and a recess formed on the upper mold 610 or the lower mold 620 may constitute the internal space 630 when the upper mold 610 and the lower mold 620 are combined.

A resin material injection portion 640 may be formed on the upper mold 610, the lower mold 620, or any one of the upper and lower molds 610 and 620 to allow a resin material to be introduced into the internal space 630 to form the radiator frame 210 allowing the antenna pattern part 110 to be embedded at the inner side of the electronic device 300 according to the internal space 630 of the upper and lower molds 610 and 620 when the upper and lower molds 610 and 620 are combined.

The resin material is filled such that the radiator 100 has the same boundary surface with the radiator frame 210 in order to smooth a flow of the resin material when the radiator frame 210 is put in the mold and injection-molded to manufacture the electronic device case 300 in which the antenna pattern is embedded.

Also, the internal space 630 of the upper and lower molds 610 and 620 may have an accommodation recess 650 for accommodating the connection part 120 and the connection terminal part 130 of the radiator 100. The resin material may be introduced into the accommodation recess 650 to fixedly support the connection part 120 and the connection terminal part 130.

Namely, because one side of the connection part 120 is in contact with one side of the accommodation recess 650, the resin material can be filled on one side of the connection part 120 to form the radiator support 220.

Here, the radiator support 220 formed by the resin material introduced into the accommodation recess 650 may be protruded from the opposite side of one side on which the antenna pattern part 110 is formed.

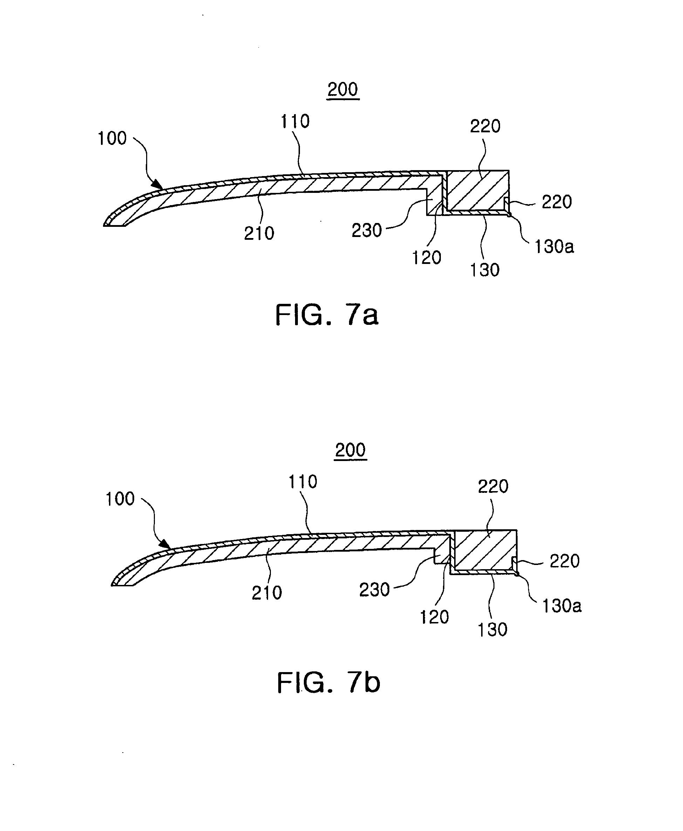

With reference to FIGS. 7a and 7b, the connection part 120 and the connection terminal part 130 may be accommodated in the accommodation recess 650 formed on the lower mold 620 of the antenna pattern frame manufacturing mold 600.

In this case, the connection part 120 and the connection terminal part 130 are inserted into the space without being in contact with the side of the accommodation recess 650 and the resin material can be in contact with the both sides of the connection part 120.

Namely, because the resin material is in contact with both sides of the connection part 120, the resin material becomes an injection reinforcing part 230 (to be described), and the resin material in contact with the other side becomes the radiator support 220.

Here, the connection terminal part 130 is bent by applying an external force in order to provide elasticity to the connection terminal part 130 in forming the electronic device case 300 having an antenna pattern embedded therein, and at this time, the injection reinforcing portion 230 serves to prevent the connection part 120 from being released from the radiator support 220.

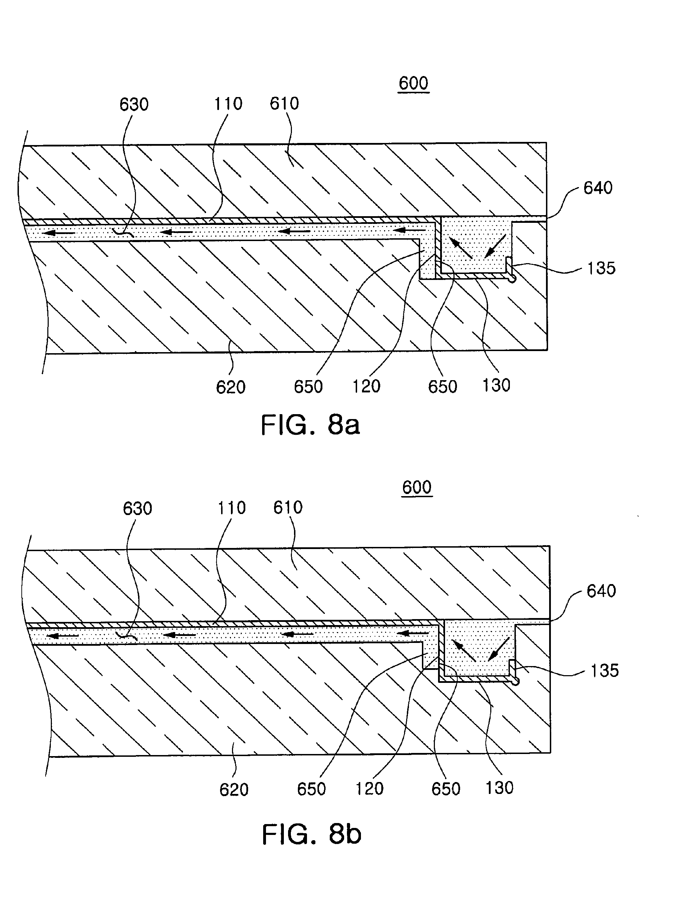

With reference to FIGS. 8a and 8b, the depth of the accommodation recess 650 formed on the lower mold 620 of the antenna pattern frame manufacturing mold 600 may be different.

This is to make the portion supporting the side of the connection part 120 after the resin material is introduced into the accommodation recess 650 different.

As mentioned above, the injection reinforcing portion 230 supporting one side of the connection part 120 may serve to prevent the connection part 120 from being released from the radiator support 220, and because no resin material is filled in the boundary between the connection part 120 and the connection terminal part 130, the connection terminal part 130 can be effectively bent in providing elasticity to the connection terminal part 130.

**Electronic device case having antenna pattern embedded therein, and a mold and method for manufacturing the same**

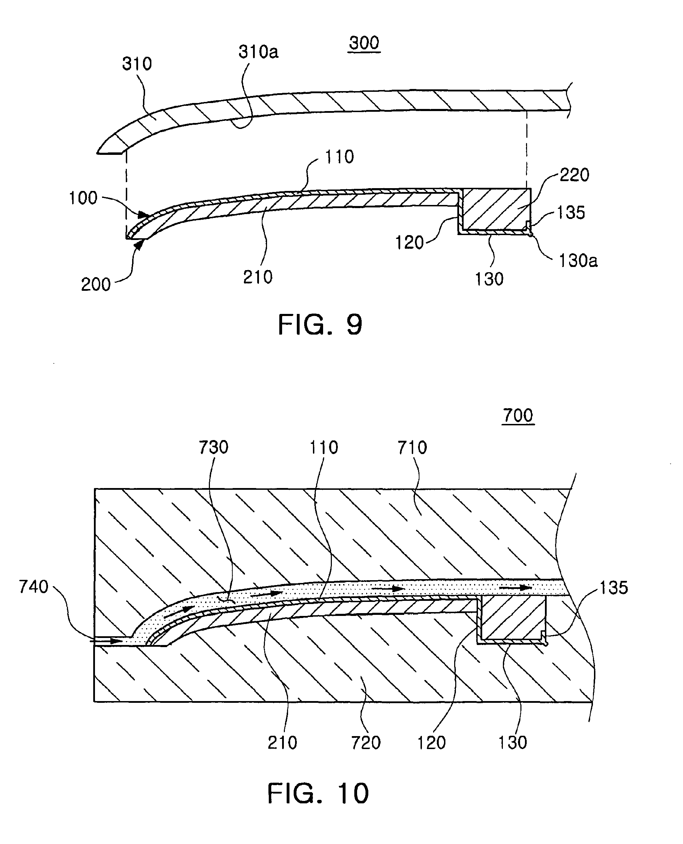

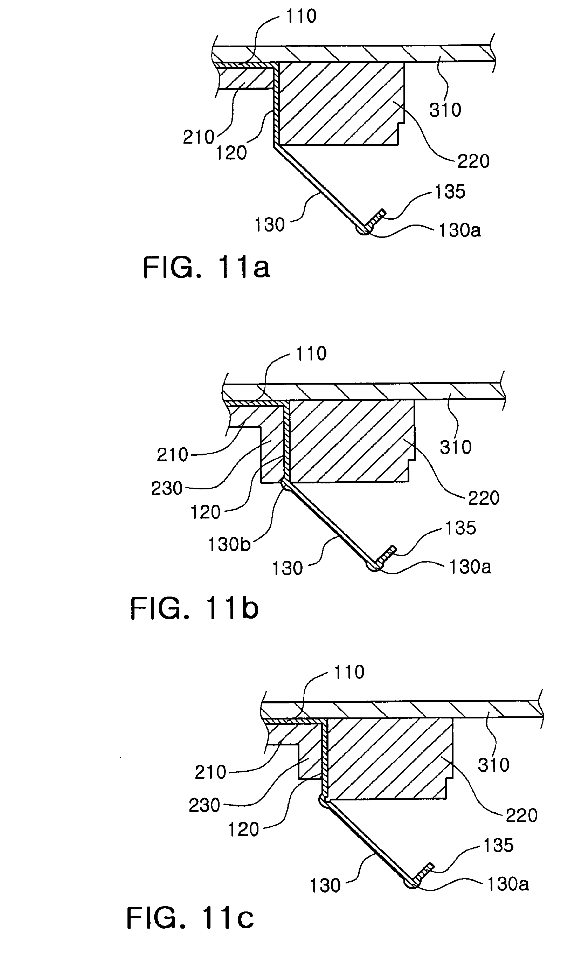

FIG. 9 is a schematic view showing an electronic device case including an antenna pattern radiator embedded therein according to another exemplary embodiment of the present invention. FIG. 10 is a schematic sectional view showing the filling of a mold with a resin material for manufacturing an electronic device case to manufacture the electronic device case including the antenna pattern embedded therein according to another exemplary embodiment of the present invention. FIGS. 11a to 11c are schematic sectional views showing an electronic device case including an antenna pattern radiator embedded therein according to another exemplary embodiment of the present invention.

With reference to FIGS. 9 and 10, the electronic device case 300 having an antenna pattern embedded therein may include an antenna pattern frame 200 and a case frame 310.

The case frame 310 may be a separate injection-molded product having a radiator accommodation recess 310a having a shape corresponding to the radiator frame 210, and the electronic device case 300 including the antenna pattern radiator embedded therein can be manufactured by attaching the radiator frame 210 to the radiator accommodation recess 310a.

In manufacturing the electronic device case 300 including the antenna pattern radiator, the antenna pattern frame 200 formed by integrating the radiator 100 and the radiator frame 210 is disposed in an electronic device case manufacturing mold 700 including an internal space 730, and a resin material is introduced thereinto to integrate the radiator frame 210 to the electronic device case 300.

The radiator frame 210 and the case frame 310 may be formed without a boundary discriminated therebetween.

Here, a resin material injection portion 740 may be formed on the upper mold, the lower mold, or on both the upper and lower molds 710 and 720 of the electronic device case manufacturing mold in which the antenna pattern frame 200 having the radiator 100 is accommodated. Thus, when the upper and lower molds 710 and 720 are combined, the resin material injection portion 740 allows a resin material to be introduced into the internal space 730 to form the electronic device case 300 according to the internal space 730 formed within the mold 700.

Through the foregoing process, the antenna pattern frame 200 and the case frame 310 may be integrated to form the electronic device case 300 having the antenna pattern embedded therein.

Here, the method for providing elasticity to the connection terminal part 130 will now be described.

With reference to FIGS. 11a to 11c, a process is performed to provide elasticity to the connection terminal part 130 of the electronic device case 300 having the antenna pattern embedded therein completely formed by introducing the resin material into the electronic device case manufacturing mold 700.

Namely, the connection terminal part 130 can be provided with elasticity through a process of separating the connection terminal part 130 in contact with the radiator support 220 by using an external force.

In this case, the connection part 120 can be prevented from being released from the radiator support 220 by means of the foregoing injection reinforcing portion 230, and the reinforcing portion 130b may be provided to the boundary between the connection part 120 and the connection terminal part 130.

The presence of the reinforcing portion 130b can further strengthen the boundary between the connection part 120 and the connection terminal part 130, and prevent the connection terminal part 130 from being damaged by an external impact.

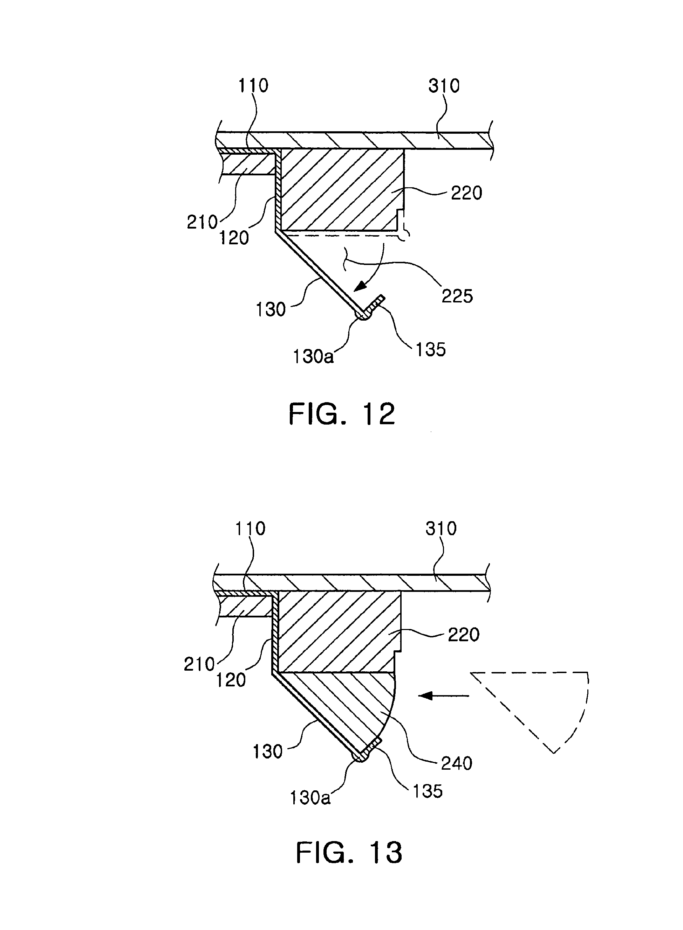

FIG. 12 is a schematic sectional view showing providing of elasticity to a connection terminal part in manufacturing the electronic device case including the antenna pattern embedded therein according to another exemplary embodiment of the present invention, and FIG. 13 is a schematic sectional view showing the inserting of an elastic member in manufacturing the electronic device case including the antenna pattern embedded therein according to another exemplary embodiment of the present invention.

With reference to FIGS. 12 and 13, an external force is applied to the connection terminal part 130 of the electronic device case 300 having the antenna pattern embedded therein completely formed by introducing the resin material into the electronic device case manufacturing mold 700 to release the connection terminal part 130 from the radiator support 220.

The connection terminal part 130 released from the radiator support 220 is provided with elasticity by a space 225 between the radiator support part 220 and the connection terminal part 130, or an elastic member 240 may be inserted into the space 225.

The elastic member 240 may be made of at least one of silicon or rubber, an insulating material, as a member for increasing elasticity of the connection terminal part 130.

Thus, when the connection terminal part 130 comes into contact with the terminal 510 of the circuit board 500, it can be effectively make an electrical connection by virtue of the elastic member 240, and a stable structure can be secured for a signal transmission.

The elastic member 240 is not an essential component of the electronic device case 300 having the antenna pattern embedded therein, and the purpose of the present invention can be achieved only with the connection terminal part 130 formed to be separated from the radiator support 220.

Through the exemplary embodiments as described above, because the connection terminal part 130 of the electronic device case 300 having the antenna pattern embedded therein has elasticity, it can be electrically connected to the circuit board without using any additional element, and can be prevented from being short-circuited by an external impact by securing a stable structure for a signal transmission.

In addition, because an additional element for an electrical connection to the circuit board is not required, a space by more than a certain size for mounting the additional element on the circuit board can be reduced.

Thus, the electronic device including the electronic device case 300 having the antenna pattern embedded therein can be reduced in size.

As set forth above, in an electronic device case having an antenna pattern embedded therein, a method for manufacturing the same, a mold for manufacturing an antenna pattern frame, and an electronic device according to exemplary embodiments of the invention, because the connection terminal part of the radiator has elasticity, it can be electrically connected to the main circuit board without using any additional element.

Also, because a stable structure is secured in transmitting a signal, a short-circuit cannot occur due to an external impact.

In addition, because an additional element is not required for an electrical connection to the main circuit board, a space by more than a certain size otherwise due to the additional element can be reduced to achieve compactness.

While the present invention has been shown and described in connection with the exemplary embodiments, it will be apparent to those skilled in the art that modifications and variations can be made without departing from the spirit and scope of the invention as defined by the appended claims.

## Claims

1. An electronic device case having antenna pattern embedded therein, the electronic device case comprising:
a radiator including an antenna pattern part transmitting or receiving a signal and a connection terminal part allowing the signal to be transmitted to or received from a circuit board of an electronic device;
a radiator frame including the radiator injection-molded thereon, separated from the connection terminal part so that the connection part can have elasticity, and having a radiator support protruded from the opposite surface of one surface on which the antenna pattern part is formed; and
a case frame covering one surface of the radiator frame to allow the antenna pattern part to be embedded between the case frame and the radiator frame.

2. The electronic device case of claim 1, wherein the connection terminal part comprises a contact projection formed to be in point-contact with the circuit board.

3. The electronic device case of claim 2, wherein the connection terminal part comprises a bent portion formed by bending one end of the connection terminal part, and the contact projection is formed on the bent portion.

4. The electronic device case of claim 1, further comprising: an elastic member provided between the connection terminal part and the radiator support to increase the elasticity of the connection terminal part.

5. The electronic device case of claim 4, wherein the elastic member is made of at least one of silicon or rubber as an insulating material.

6. The electronic device case of claim 1, wherein the radiator comprises a connection part, as part of the radiator, connecting the antenna pattern part and the connection terminal part, and the connection part connects the antenna pattern part and the connection terminal part such that the antenna pattern part is formed on one surface of the radiator frame and the connection terminal part is formed on the opposite surface of the one surface.

7. The electronic device case of claim 6, wherein the connection part is supported such that one surface of the connection part is in contact with the radiator support.

8. The electronic device case of claim 6, further comprising: at least one reinforcing portion formed at the boundary between the connection part and the connection terminal part to secure an elastic force of the connection terminal part.

9. The electronic device case of claim 8, wherein the reinforcing portion is a reinforcing bead formed to be protruded at the boundary between the connection part and the connection terminal part.

10. The electronic device case of claim 8, wherein the reinforcing portion is formed make the boundary between the connection part and the connection terminal part rounded.

11. The electronic device case of claim 6, further comprising: an injection reinforcing portion formed to be in contact with one side of the connection part to prevent the connection part from being released from the radiator support.

12. The electronic device case of claim 11, wherein the injection reinforcing portion is integrally formed with the radiator frame.

13. An electronic device comprising:
an electronic device case having an antenna pattern embedded therein according to any one of claim 1 to claim 12; and
a circuit board connected to a connection terminal part to transmit and receive a signal of a radiator.

14. The electronic device of claim 13, wherein the electronic device case having antenna pattern embedded therein comprises a fastening part formed on at least one side of the electronic device case and coupled with a main case forming an external appearance of the electronic device.

15. The electronic device of claim 14, wherein the fastening part is protruded from one side of the electronic device case having the antenna pattern embedded therein, and the main case includes a fastening line recess corresponding to the fastening part to allow the fastening part to be inserted into the fastening line recess and slidably coupled therein.

16. A mold for manufacturing an antenna pattern frame, the mold comprising:
upper and lower molds in which a radiator, including an antenna pattern part for transmitting and receiving a signal, a connection terminal part connected to a circuit board of an electronic device, and a connection part connecting the antenna pattern part and the connection terminal part, is accommodated; and
a resin material injection part formed on the upper mold, the lower mold or on at least one of the upper and lower molds to allow a resin material to be introduced into an internal space between the upper and lower molds so as to form a radiator frame allowing the antenna pattern to be embedded in the interior of the electronic device by the internal space between the upper and lower molds when the upper and lower molds are combined,
wherein the lower mold includes an accommodation recess for accommodating the connection part and the connection terminal part, the resin material is introduced into the accommodation recess to support both sides of the connection part, and the radiator becomes the radiator frame by the internal space.

17. The mold of claim 16, wherein the accommodation recess has different depths based on the connection part as a boundary so that portions supporting the side of the connection part can be different.

18. A method for manufacturing an electronic device case having an antenna pattern embedded therein, the method comprising:
injection-molding a radiator frame having a radiator such that an antenna pattern part for transmitting and receiving a signal and a connection terminal part allowing the signal to be transmitted to or received from a circuit board of an electronic device are disposed on different planes of the radiator;
injection-molding a case frame covering one surface of the radiator frame to make the antenna pattern part embedded between the case frame and the radiator frame; and
separating the connection terminal part from the case frame and providing elasticity to the connection terminal part.

19. The method of claim 18, wherein the radiator frame comprises a radiator support protruded from the opposite surface of one surface on which the antenna pattern part is formed in order to allow the connection terminal part to have elasticity.

20. The method of claim 18, further comprising:
inserting an elastic member between the connection terminal part and the case frame in order to increase the elasticity of the connection terminal part, after elasticity is provided to the connection terminal part.

21. The method of claim 20, wherein the elastic member is made of at least one of silicon or rubber as an insulating material.

22. The method of claim 18, wherein the radiator comprises a connection part, as part of the radiator, connecting the antenna pattern part and the connection terminal part such that the antenna pattern part and the connection terminal part are positioned on different planes, and also comprises at least one reinforcing portion formed at a boundary between the connection part and the connection terminal part to secure an elastic force of the connection terminal part.

23. The method of claim 22, wherein the radiator frame comprises a radiator support protruded from the opposite surface of one surface on which the antenna pattern part is formed to allow the connection terminal part to have elasticity, and the connection part is supported such that one side of the connection part is in contact with the radiator support.
